# EUROPEAN PATENT APPLICATION

(11) **EP 4 836 297 A1**
(43) Date of publication of application: **04.11.2026**
(21) Application number: 26175385.9
(22) Date of filing: 29.04.2026
(51) Int. Cl.: H03H 9/02, H03H 9/17

(54) **BULK ACOUSTIC WAVE RESONATOR**

(30) Priority: 30.04.2025 US 202519195447
(71) Applicant: Avago Technologies International Sales Pte. Limited, Singapore 768923 (SG)
(72) Inventor: Ben Hassine, Nizar, San Jose, 95127 (US); Kirkendall, Christopher Reed, Morgan Hill, 95037 (US); Strathman, Matthew, Severance, 80550 (US)
(74) Representative: Dilg, Haeusler, Schindelmann Patentanwaltsgesellschaft mbH

(57) **Abstract**

An example bulk acoustic wave (BAW) resonator includes: a first electrode; a second electrode; a piezoelectric layer disposed between the first electrode and the second electrode; a substrate on which the first electrode, the second electrode, and the piezoelectric layer are disposed, the second electrode disposed between the substrate and the piezoelectric layer; an active area comprising a region of overlap of the first electrode, the piezoelectric layer, and the second electrode; and a frame disposed on the piezoelectric layer surrounding the active area; wherein the piezoelectric layer has a first thickness in the active area and a second thickness under the frame, the second thickness different than the first thickness.

## Description

### BACKGROUND

Electrical resonators can be used in modem electronic devices. For example, in wireless communications devices, radio frequency (RF) resonators can be used in filters, such as filters having electrically connected series and shunt resonators forming ladder and lattice structures. The filters may be included in circuits connected between an antenna and a transceiver for filtering received and transmitted signals.

Various types of filters use mechanical resonators, such as bulk acoustic wave (BAW) resonators, including film bulk acoustic resonators (FBARs) and solidly mounted resonators (SMRs), or surface acoustic wave (SAW) resonators. The resonators can convert electrical signals to mechanical signals (e.g., vibrations), and mechanical signals to electrical signals. A BAW resonator, for example, is an acoustic device comprising a stack that can include a layer of piezoelectric material between two electrodes. Acoustic waves can achieve resonance across the acoustic stack, with the resonant frequency of the waves being determined by the materials in the acoustic stack and the thickness of each layer (e.g., piezoelectric layer and electrode layers). One type of BAW resonator can include a piezoelectric film as the piezoelectric material, which may be referred to as an FBAR as noted above. FBARs can resonate at GHz frequencies, and are thus relatively compact, e.g., can have thicknesses on the order of microns and length and width dimensions of hundreds of microns. BAW resonators such as FBARs can suffer from acoustic losses. The acoustic losses can have an adverse impact on the performance and reliability of the resonators and the filters that are used to implement. It is therefore desirable to mitigate acoustic losses in resonators, e.g., resonators used by filters in electronic devices.

### SUMMARY

In some embodiments, a bulk acoustic wave (BAW) resonator can include a first electrode, a second electrode, and a piezoelectric layer disposed between the first electrode and the second electrode. The BAW resonator can include a substrate on which the first electrode, the second electrode, and the piezoelectric layer are disposed. The second electrode can be disposed between the substrate and the piezoelectric layer. The BAW resonator can include an active area comprising a region of overlap of the first electrode, the piezoelectric layer, and the second electrode. The BAW resonator can include a frame disposed on the piezoelectric layer surrounding the active area. The piezoelectric layer can have a first thickness in the active area and a second thickness under the frame, the second thickness different than the first thickness.

In some embodiments, an integrated circuit (IC) can include a substrate having a first electrode layer, a second electrode layer, and a piezoelectric layer. The IC can include a first bulk acoustic wave (BAW) resonator comprising a first active area and a first frame. The first active area can include a first region of overlap of the first electrode layer, the piezoelectric layer, and the second electrode layer. The first frame can be disposed on the piezoelectric layer surrounding the first active area. The IC can include a second BAW resonator comprising a second active area and a second frame. The second active area can include a second region of overlap of the first electrode layer, the piezoelectric layer, and the second electrode layer. The second frame can be disposed on the piezoelectric layer surrounding the second active area. The piezoelectric layer can have a first thickness in the first and second active areas and a second thickness under the first and second frames, the second thickness different than the first thickness.

In some embodiments, an apparatus can include a first circuit and an electrical filter coupled to the first circuit. The electrical filter can include a bulk acoustic wave (BAW) resonator. The BAW resonator can include a first electrode, a second electrode, and a piezoelectric layer disposed between the first electrode and the second electrode. The BAW resonator can include a substrate on which the first electrode, the second electrode, and the piezoelectric layer are disposed. The second electrode can be disposed between the substrate and the piezoelectric layer. The BAW resonator can include an active area comprising a region of overlap of the first electrode, the piezoelectric layer, and the second electrode. The BAW resonator can include a frame disposed on the piezoelectric layer surrounding the active area. The piezoelectric layer can have a first thickness in the active area and a second thickness under the frame, the second thickness different than the first thickness.

### BRIEF DESCRIPTION OF THE DRAWINGS

Fig. 1A is a block diagram of a device in which BAW resonators according to some embodiments can be used.
Fig. 1B is a schematic diagram depicting an electrical filter in which BAW resonators according to some embodiments can be used.
Fig. 2 is a block diagram depicting a BAW resonator according to some embodiments.
Fig. 3A is a top view of a BAW resonator according to some embodiments.
Fig. 3B is a cross-sectional view of the BAW resonator depicted in Fig. 3A taken along line 3B-3B according to some embodiments.
Fig. 3C is a side view of a piezoelectric layer of the BAW resonator depicted in Figs. 3A-3B according to some embodiments.
Fig. 4 is a flow diagram depicting a method of forming a BAW resonator according to some embodiments.

### DETAILED DESCRIPTION

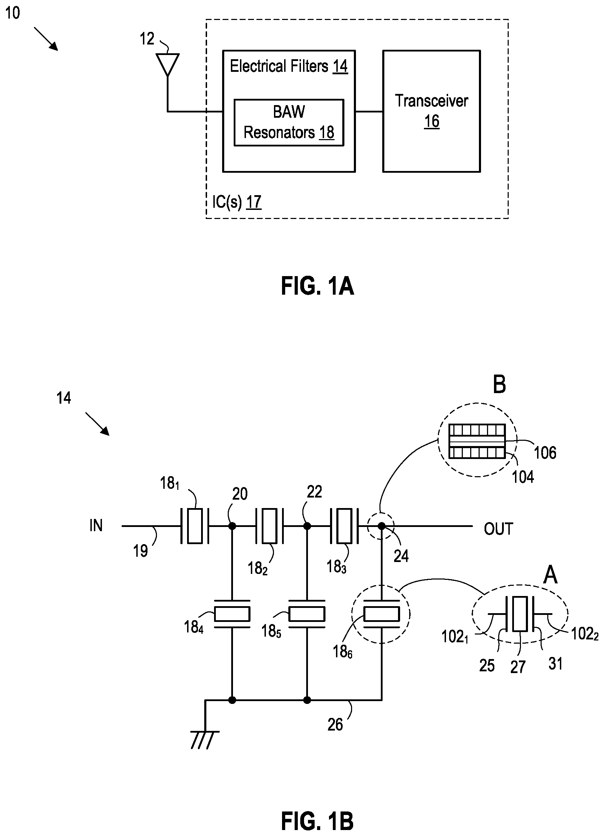

Fig. 1A is a block diagram of a device 10 in which BAW resonators according to some embodiments can be used. Device 10 can include an antenna 12, electrical filters 14, and a transceiver 16. An antenna may be a device that can convert an electrical signal to radio waves or radio waves to an electrical signal. A signal may be any time-varying quantity (e.g., voltage, current, charge, electromagnetic wave, etc.). An electrical signal may be a signal conveyed by a time-varying electrical parameter, such as voltage, current, charge, etc. Antenna 12 can transmit to, and receive from, a radio transmission medium, which may be a medium configured to carry radio signals (e.g., air). A radio wave or radio signal may be an electromagnetic (EM) wave in the radio/microwave part of the EM spectrum. An electrical filter may be a device configured to pass (or amplify) certain frequencies, and block (or attenuate) other frequencies, of an electrical signal. A transceiver may be a device configured to transmit and receive signals (e.g., electrical signals). Transceiver 16 can couple electrical signals for transmission to antenna 12 through electrical filters 14. Transceiver 16 can receive electrical signals from antenna 12 through electrical filters 14. Electrical filters 14 can include circuits comprising BAW resonators 18. A BAW resonator may be an acoustic resonator in which mechanical (acoustic) waves can travel through the thickness (bulk) of its piezoelectric material. A piezoelectric material may be a dielectric material that enables conversion between electrical and elastic energy. Some embodiments of BAW resonators 18 are described below. Electrical filters 14 and transceiver 16 may be part of one or more integrated circuits (ICs). An IC may be a device formed on a substrate (e.g., a semiconductor substrate).

Fig. 1B is a schematic diagram depicting an electrical filter in which BAW resonators according to some embodiments can be used. An electrical filter 14 can include BAW resonators 18₁...18₆. BAW resonator 18₁ can be coupled between nodes 19 and 20. A node may be a point in a circuit where two or more circuit elements are connected. A node can be shown in the drawings as a filled circle at a wire junction. Wires that cross each other without a node or with a jump are not connected. Note that, for ease of illustration, a node may be shown as two or more separate junctions connected by only wire(s) and no circuit elements (e.g., a short-circuit connection). In such case, a reference numeral assigned to the node can be at one of the junctions or at one of the wires between the junctions, all of which collectively represent the node. BAW resonator 18₂ can be coupled between node 20 and a node 22. BAW resonator 18₃ can be coupled between node 22 and a node 24. BAW resonator 18₄ can be coupled between node 20 and a node 26. BAW resonator 18₅ can be coupled between node 22 and node 26. BAW resonator 18₆ can be coupled between node 24 and node 26. Node 26 can be coupled to electrical ground. Electrical ground may be a reference voltage against which other voltages in a circuit can be compared (e.g., 0V). Node 19 can be an input of electrical filter 14 and node 24 can be an output of electrical filter 14.

As shown in detail A, a BAW resonator 18 can include a first electrode 25, a piezoelectric structure 27, and a second electrode 31. First electrode 25 can be a first terminal 102₁ of BAW resonator 18 and second electrode 31 can be a second terminal 102₂ of BAW resonator 18. A terminal of a device may be a point of electrical connection. As shown in detail B, BAW resonators 18₁...18₆ can be electrically coupled through a conductive interconnect of an IC 17. A conductive interconnect may be conductive layers 104 separated by dielectric layers 106 formed on a substrate of an IC. A layer may be a material formed on a substrate. A layer can be adhered to the substrate or another layer. A layer can be uniform, e.g., uniform surface area, uniform thickness, or both. A layer can be patterned, e.g., non-uniform surface area, non-uniform thickness, or both. A layer can be patterned into disjoint portions, e.g., electrically isolated portions. A conductive layer may be a layer of conductive material (e.g., metal). A dielectric layer may be a layer of dielectric material (e.g., various dielectric materials used in ICs are well known in the art). One or more conductive layers 104 can be patterned to electrically couple the terminals of BAW resonators 18₁...18₆ to form nodes 19, 20, 22, 24, and 26.

Each BAW resonator 18₁...18₆ can have a resonance frequency and an anti-resonance frequency. A resonance frequency (also referred to as a resonant frequency) may be a frequency at which the resonator has minimum impedance. An anti-resonance frequency (also referred to as an anti-resonant frequency) may be a frequency at which the resonator has maximum impedance. The resonance and anti-resonance frequencies can be determined by the construction of the BAW resonator. For example, the frequency at which a BAW resonates can be dictated at least in part by the thickness and material properties of its piezoelectric layer. BAW resonators 18₁...18₃ can series resonators between nodes 19 and 24. A series resonator can allow the transmission of an electrical signal having a frequency at or near the resonance frequency and can block the transmission of an electrical signal having a frequency at or near the anti-resonance frequency. BAW resonators 18₄...18₆ can be shunt resonators to node 26. A shunt resonator can operate inversely to a series resonator. That is, a shunt resonator can block the transmission of an electrical signal having a frequency at or near the resonance frequency and allow the transmission of an electrical signal at or near the anti-resonance frequency. The combination of series and shunt resonators, e.g., BAW resonators 18₁...18₆, can make a frequency band where an electrical signal having a frequency within a band can pass from input (IN) to output (OUT) (referred to as a pass band) and an electrical signal having a frequency outside the band is blocked from passing from input (IN) to output (OUT).

Some embodiments of a BAW resonator having a construction that mitigates acoustic losses are described herein. Device 10 can be one example type of device in which the BAW resonator according to embodiments can be used (e.g., a mobile telephone or the like type of device that receives and transmits radio waves). However, the BAW resonator according to embodiments can be used in any type of device having electrical filter(s). The bandpass filter of Fig. 1B is one example type of electrical filter in which the BAW resonator according to embodiments can be used. The BAW resonator described herein can be a series resonator or shunt resonator and can be combined with other BAW resonators to form an electrical filter, such as a bandpass filter as shown in the example or any other type of electrical filter known in the art (e.g., a notch filter).

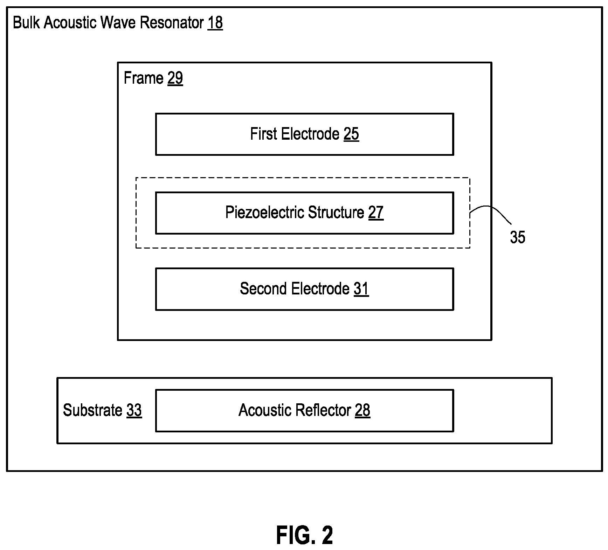

Fig. 2 is a block diagram depicting a BAW resonator 18 according to some embodiments. BAW resonator 18 can include a first electrode 25, piezoelectric structure 27, a second electrode 31, and a frame 29. BAW resonator 18 can also include a substrate 33 on which layers are formed to provide first electrode 25, piezoelectric structure 27, second electrode 31, and frame 29. In some embodiments, first electrode 25 may include a first surface and an opposing second surface. Piezoelectric structure 27 may also include a first surface and an opposing second surface. The first surface of piezoelectric structure 27 may face toward the second surface of first electrode 25. Second electrode 116 may also include a first surface and an opposing second surface. The first surface of second electrode 31 may face toward the second surface of piezoelectric structure 27. This configuration of first electrode 25, piezoelectric structure 27, and second electrode 31 may result in piezoelectric structure 27 being sandwiched between first electrode 25 and second electrode 31.

First electrode 25 and second electrode 31 may be formed of the same material or of different materials. An electrode of a device may be a conductor through which electricity can enter or leave. For example, first electrode 25 and second electrode 31 may be formed of one or more electrically conductive materials (e.g., molybdenum (Mo), W, Pt, Ru, Al, Ta, Cu, or Ru or the like known in the art). Piezoelectric structure 27 may include a piezoelectric material (e.g., AlN or the like known in the art). A piezoelectric structure may be an arrangement of piezoelectric material (e.g., part of a piezoelectric layer formed on a substrate). Frame 29 may be formed from one or more dielectric materials or metal material. A frame of a BAW resonator may be a structure that surrounds an active area of the resonator. An active area of a BAW resonator may be a region that can generate and sustain acoustic resonance. The active area can be implemented as a region of overlap of first electrode 25, piezoelectric structure 27, and second electrode 31. Frame 29 can be formed on a piezoelectric layer 35 having piezoelectric structure 27. The area of piezoelectric layer 35 occupied by frame 29 may be referred to as a frame area. The frame area can be adjacent to the active area. In some embodiments, piezoelectric layer 35 can be thinner in the frame area than in the active area, as discussed further below.

Substrate 33 can be adjacent to the second surface of second electrode 31. A substrate may be a structure on which layers can be formed. Thus, in some embodiments, a stack of first electrode 25, piezoelectric structure 27, and second electrode 31 may be supported by substrate 33. Substrate 33, in some embodiments, may include silicon, but other materials, such as gallium arsenide (GaAs) and indium phosphide (InP), are contemplated.

Substrate 33 can include an acoustic reflector 28. An acoustic reflector of a BAW resonator may be a structure that functions to acoustically isolate the active area from the substrate. Acoustic reflector 28 can be a cavity formed in substrate 33 (e.g., a cavity filled with air). Alternatively, acoustic reflector 28 can be a cavity in substrate 33 at least partially filled with material, such as an acoustic reflective material known in the art (e.g., alternating layers of high acoustic impedance material and low acoustic impedance materials).

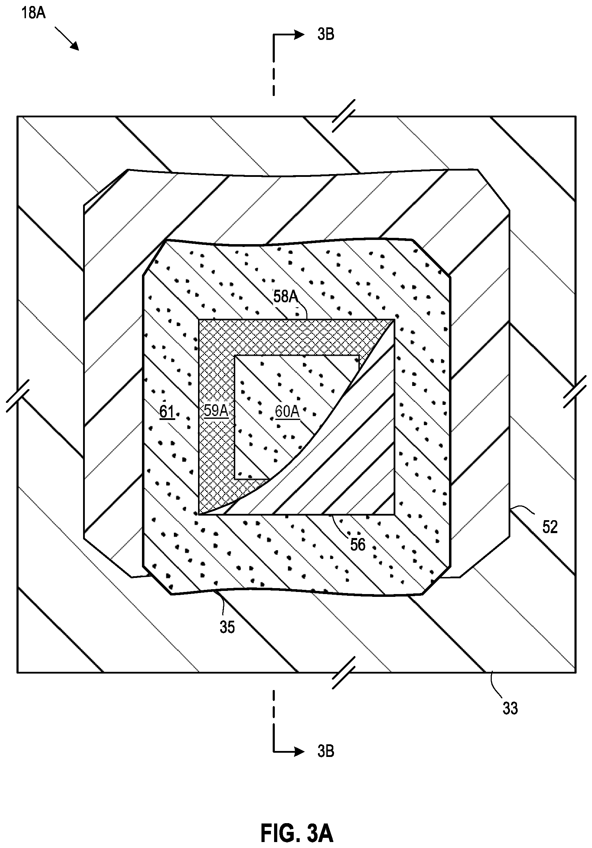

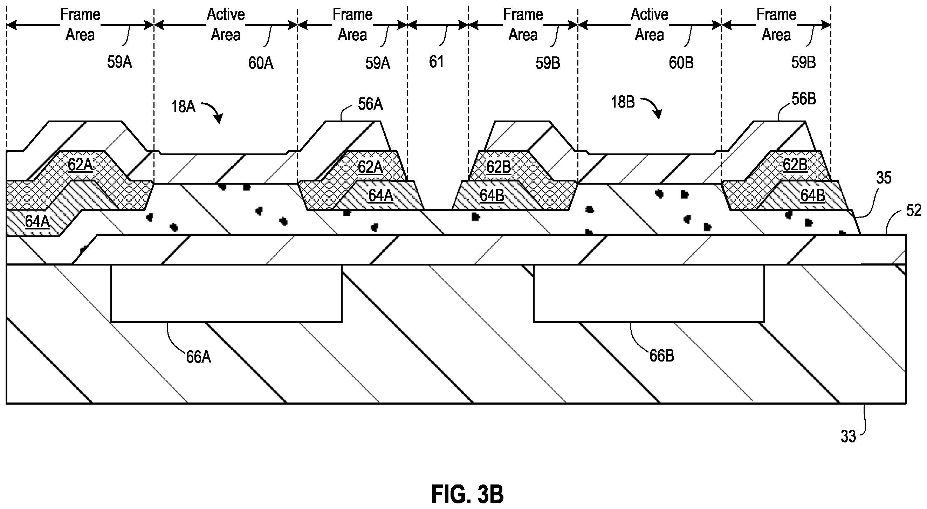

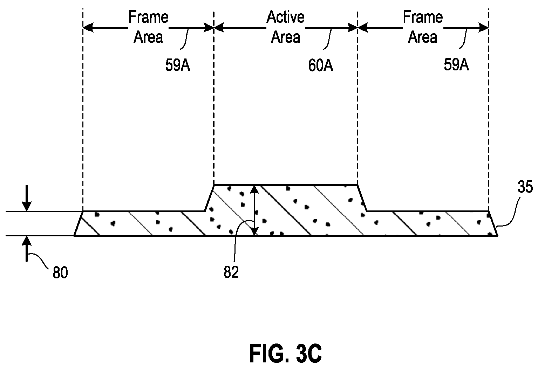

Figs. 3A-C depict views of an IC having BAW resonators according to some embodiments. Fig. 3A is a top view showing a portion of the IC according to some embodiments. Fig. 3B is a cross-sectional view of the IC depicted in Fig. 3A taken along line 3B-3B according to some embodiments. Fig. 3C is a side view of a piezoelectric layer of a BAW resonator depicted in Figs. 3A-B according to some embodiments.

As shown in Fig. 3A, a BAW resonator 18A can be formed using layers on substrate 33. A portion of substrate 33 is shown in Fig. 3A. The layers can include a first electrode layer 56, a piezoelectric layer 35, and a second electrode layer 52. Portions of first electrode layer 56, piezoelectric layer 35, and second electrode layer 52 are shown in Fig. 3A. Second electrode layer 52 can be disposed between substrate 33 and piezoelectric layer 35. Piezoelectric layer 35 can be disposed between second electrode layer 52 and first electrode layer 56. Second electrode layer 52 can be patterned to form second electrode 31. First electrode layer 56 can be patterned to form first electrode 25. Piezoelectric layer 35 can be patterned to form piezoelectric structure 27. BAW resonator 18A can include frame 29 (shown in Fig. 3B) that can occupy a frame area 59A on piezoelectric layer 35. Frame area 59A can surround an active area 60A of BAW resonator 18A. As shown in Figs. 3B-C and discussed below, piezoelectric layer 35 can be thinner in frame area 59A than in active area 60A. An area 61 of piezoelectric layer 36 can be an area other than active area 60 and frame area 59A. In some embodiments, all or a portion of area 61 of piezoelectric layer 35 can have a different thickness in active area 60A than in frame area 59A.

As shown in Fig. 3B, the IC can include BAW resonators 18A and 18B. First electrode layer 56 can be patterned into portions 56A and 56B. Portion 56A of first electrode layer 56 can be first electrode 35 of BAW resonator 18A. Portion 56B of first electrode layer 56 can be first electrode 35 of BAW resonator 18B. In this example, second electrode layer 52 can be formed on substrate 33 and can be used by both BAW resonators 18A and 18B as respective second electrodes 31 that are electrically coupled. In other examples, second electrode layer 52 can be patterned to form separate second electrodes 31 for BAW resonators 18A and 18B that are not electrically coupled. Substrate 33 can include cavities 66A and 66B (e.g., filled with air). Cavities 66A and 66B can be an acoustic reflector 28 of BAW resonators 18A, and 18B, respectively. Second electrode layer 52 can overlap cavities 66A and 66B in their entirety.

Piezoelectric layer 35 can be formed on substrate 33 and second electrode layer 52. Piezoelectric layer 35 can be used by both BAW resonators 18A and 18B as respective piezoelectric structures 27. In the example, piezoelectric layer 35 can include a first portion disposed on substrate 33 and a second portion disposed on second electrode layer 52. Second electrode layer 52 can include a first portion covered by piezoelectric layer 35 and a second portion uncovered by piezoelectric layer 35.

In some embodiments, a layer 62 can be formed on piezoelectric layer 35 to form a least a portion of frame 29 of each BAW resonator 18A and 18B. Layer 62 can be a dielectric material. Layer 62 can be patterned to form a frame portion 62A and a frame portion 62B. Frame portion 62A can be all or a part of frame 29 of BAW resonator 18A and frame portion 62B can be all or a part of frame 29 of BAW resonator 18B. Frame portion 62A can surround an active area 60A of BAW resonator 18A. Frame portion 62B can surround an active area 60B of BAW resonator 18B. In some embodiments, a layer 64 can be formed on piezoelectric layer 35 to form another portion of frame 29 of each BAW resonator 18A and 18B. Layer 64 can be a dielectric material (e.g., the same as or different from layer 62). Layer 64 can be patterned to form wing portions 64A and wing portions 64B. A wing of a BAW resonator may be a part of the resonator outside of the active area that can provide functions of stress relief, energy mitigation, and the like known in the art. A wing can be part of the frame of a BAW resonator. In the example, wing portions 64A can be disposed on piezoelectric layer 35. A first portion of frame portion 62A can be disposed on wing portions 64A. A second portion of frame portion 62A can be formed on piezoelectric layer 35. Likewise, wing portions 64B can be disposed on piezoelectric layer 35. A first portion of frame portion 62B can be disposed on wing portions 64B. A second portion of frame portion 62B can be formed on piezoelectric layer 35. In other embodiments, wing portions 64A and 64B can be cavities (e.g., filled with air) rather than material of a layer.

Frame portion 62A and wing portions 64A of BAW resonator 18A can occupy frame area 59A. Frame portion 62B and wing portions 64B of BAW resonator 18B can occupy frame area 59B. Frame area 59A can surround active area 60A. Frame area 59B can surround active area 60B. Fig. 3B shows a portion of area 61 other than the active and frame areas (e.g., an area between BAW resonators 18A and 18B).

Portion 56A of first electrode layer 56 can be formed on frame portions 62A and piezoelectric layer 35. Portion 56B of first electrode layer 56 can be formed on frame portions 72B and piezoelectric layer 35. In some embodiments, portion 56A of first electrode layer 56, a portion of piezoelectric layer 35 (e.g., piezoelectric structure 27), and a portion of second electrode layer 52 form a stack within active area 60A. As shown in Fig. 3C, piezoelectric layer 35 has a thickness 82 within active area 60A. Piezoelectric layer 35 has a thickness 80 in frame area 59A. In some embodiments, thickness 82 can be different than thickness 80, such as greater than thickness 80 or less than thickness 80. In some embodiments, piezoelectric layer 35 can be thinner in frame area 59A than in active area 60A. Reducing the thickness of piezoelectric layer 35 within frame area 59A can reduce the coupling of parasitic modes and can improve acoustic losses through the frame. In addition, reducing the thickness of piezoelectric layer 35 within the frame area 59A can allow layers 62A/64A to be thicker for a given height of the BAW resonator. Likewise, portion 56B of first electrode layer 56, a portion of piezoelectric layer 35 (e.g., piezoelectric structure 27), and a portion of second electrode layer 52 form a stack within active area 60B. Piezoelectric layer 35 can have a thickness 80 in frame area 59B and a thickness 82 in active area 60B.

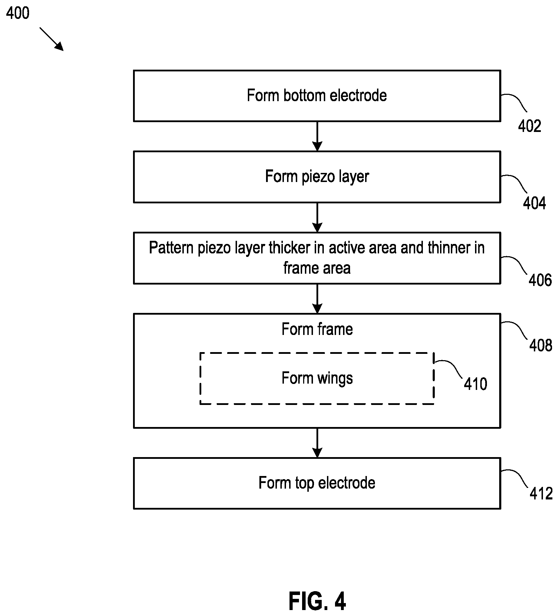

Fig. 4 is a flow diagram depicting a method 400 of forming a BAW resonator according to some embodiments. Method 400 can be performed using one or more machines used in construction of ICs, which are well known in the art. Method 400 can begin at step 402, where a bottom electrode can be formed on a substrate (e.g., second electrode 31). At step 404, a piezoelectric layer can be formed on the substrate and bottom electrode. At step 406, the piezoelectric layer can be patterned to be thicker in the active area and thinner in the frame area of the BAW resonator. At step 408, a frame can be formed on the piezoelectric layer. The frame can occupy the frame area and can surround the active area. At optional step 410, wings can be formed in the frame (e.g., either using dielectric material or cavities). At step 412, a top electrode can be formed on the piezoelectric layer and the frame (e.g., first electrode 25.

While some processes and methods having various operations may be described, one or more embodiments also relate to a device or an apparatus for performing these operations. The apparatus may be specially constructed for required purposes, or the apparatus may be or include a general-purpose computer selectively activated or configured by a computer program stored in the computer. Various general-purpose machines may be used with computer programs written in accordance with the teachings herein, or it may be more convenient to construct a more specialized apparatus to perform the required operations.

As used herein, the phrase "at least one of' preceding a series of items, with the term "and" or "or" to separate any of the items, modifies the list as a whole, rather than each member of the list (i.e., each item). The phrase "at least one of" does not require selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C ," or alternatively, "at least one of A, at least one of B, and at least one of C," it is expressly described as such.

As used herein, the term "couple" and its derivatives include: (a) electrical and communicative coupling; and (b) do not imply a direct connection, but rather may include intervening elements, unless described as "directly coupled."

Relative terms, such as "above," "below," "top," "bottom," "upper" and "lower" may be used to describe the various elements' relationships to one another, as illustrated in the accompanying drawings. These relative terms are intended to encompass different orientations of the device and/or elements in addition to the orientation depicted in the drawings. For example, if the device were inverted with respect to the view in the drawings, an element described as "above" another element, for example, would now be "below" that element. Similarly, if the device were rotated by 90 degrees with respect to the view in the drawings, an element described "above" or "below" another element would now be more generally described as "adjacent" to the other element; where "adjacent" means either abutting the other element, or having one or more layers, materials, structures, etc., between the elements.

As used in the specification and the appended claims and in addition to its ordinary meaning, the term 'approximately' means to within an acceptable limit or amount to one having ordinary skill in the art. For example, 'approximately the same' means that one of ordinary skill in the art would consider the items being compared to be the same. As used in the specification and appended claims, and in addition to their ordinary meanings, the terms 'substantial' or 'substantially' mean to within acceptable limits or degree. For example, 'substantially cancelled' means that one skilled in the art would consider the cancellation to be acceptable.

Although one or more embodiments of the present invention have been described in some detail for clarity of understanding, certain changes may be made within the scope of the claims. Accordingly, the described embodiments are to be considered as illustrative and not restrictive, and the scope of the claims is not to be limited to details given herein but may be modified within the scope and equivalents of the claims. In the claims, elements and/or steps do not imply any particular order of operation unless explicitly stated in the claims.

Boundaries between components, operations, and data stores are somewhat arbitrary, and particular operations are illustrated in the context of specific illustrative configurations. Other allocations of functionality are envisioned and may fall within the scope of the invention. In general, structures and functionalities presented as separate components in exemplary configurations may be implemented as a combined structure or component. Similarly, structures and functionalities presented as a single component may be implemented as separate components. These and other variations, additions, and improvements may fall within the scope of the appended claims.

## Claims

1. A bulk acoustic wave, BAW, resonator, comprising:
a first electrode;
a second electrode;
a piezoelectric layer disposed between the first electrode and the second electrode;
a substrate on which the first electrode, the second electrode, and the piezoelectric layer are disposed, the second electrode disposed between the substrate and the piezoelectric layer;
an active area comprising a region of overlap of the first electrode, the piezoelectric layer, and the second electrode; and
a frame disposed on the piezoelectric layer surrounding the active area;
wherein the piezoelectric layer has a first thickness in the active area and a second thickness under the frame, the second thickness different than the first thickness.

2. The BAW resonator of claim 1, wherein
the frame includes a wing and wherein the piezoelectric layer has the second thickness under the wing.

3. The BAW resonator of claim 1 or 2, wherein
the frame comprises a first material being a dielectric material or a metal, a first portion of the first material disposed on the piezoelectric layer.

4. The BAW resonator of any one of the claims 1 to 3, wherein
the frame is disposed between a first portion of the piezoelectric layer having the second thickness and the first electrode.

5. The BAW resonator of claim 4, wherein
the first portion of the piezoelectric layer is disposed between the frame and the second electrode.

6. The BAW resonator of claim 5, wherein
a second portion of the piezoelectric layer having the second thickness is disposed on the substrate outside a perimeter of the second electrode, and wherein the frame is disposed on the second portion of the piezoelectric layer.

7. The BAW resonator of claim 6, wherein
a third portion of the piezoelectric layer having the second thickness is disposed on the substrate outside a perimeter of the frame.

8. The BAW resonator of any one of the claims 1 to 7, wherein
the substrate comprises an acoustic reflector, and wherein the active area overlaps the acoustic reflector;
wherein in particular
the acoustic reflector comprises a one or more layers of material or a cavity.

9. An integrated circuit, IC, comprising:
a substrate having a first electrode layer, a second electrode layer, and a piezoelectric layer;
a first bulk acoustic wave, BAW, resonator comprising a first active area and a first frame,
the first active area comprising a first region of overlap of the first electrode layer, the piezoelectric layer, and the second electrode layer,
the first frame disposed on the piezoelectric layer surrounding the first active area;
a second BAW resonator comprising a second active area and a second frame, the second active area comprising a second region of overlap of the first electrode layer, the piezoelectric layer, and the second electrode layer, the second frame disposed on the piezoelectric layer surrounding the second active area;
wherein the piezoelectric layer has a first thickness in the first and second active areas and a second thickness under the first and second frames, the second thickness different than the first thickness.

10. The IC of claim 9, wherein
a first electrode of the first BAW resonator, the first electrode disposed in one of the first electrode layer or the second electrode layer, is electrically coupled to a second electrode of the second BAW resonator, the second electrode disposed in one of the first electrode layer or the second electrode layer.

11. The IC of claim 9 or 10, wherein
the first frame includes a first wing and the second frame includes a second wing, and wherein the piezoelectric layer has the second thickness under the first and second wings; wherein in particular
the first and second frames comprise a first layer being dielectric or metal, and wherein the first and second wings comprise a second dielectric layer, or cavities, disposed between the piezoelectric layer and the first dielectric layer.

12. The IC of any one of the claims 9 to 11, wherein
the piezoelectric layer includes a portion between the first and second BAW resonators, the portion having the second thickness:
wherein in particular
the portion between the first and second BAW resonators is disposed outside perimeters of the first and second frames.

13. The IC of any one of the claims 9 to 12, wherein
the substrate includes a first acoustic reflector and a second acoustic reflector, and wherein
the first active area overlaps the first acoustic reflector and the second active area overlaps the second acoustic reflector.

14. An apparatus, comprising:
a first circuit; and
an electrical filter coupled to the first circuit, the electrical filter comprising a bulk acoustic wave, BAW, resonator, the BAW resonator comprising:
a first electrode;
a second electrode;
a piezoelectric layer disposed between the first electrode and the second electrode;
a substrate on which the first electrode, the second electrode, and the piezoelectric layer are disposed, the second electrode disposed between the substrate and the piezoelectric layer;
an active area comprising a region of overlap of the first electrode, the piezoelectric layer, and the second electrode; and
a frame disposed on the piezoelectric layer surrounding the active area;
wherein the piezoelectric layer has a first thickness in the active area and a second thickness under the frame, the second thickness different than the first thickness;
wherein in particular
the first circuit comprises a transceiver, and wherein the electrical filter is coupled between the transceiver and an antenna.

15. The apparatus of claim 14, wherein
the frame is disposed between a first portion of the piezoelectric layer having the second thickness and the first electrode;
wherein in particular
a second portion of the piezoelectric layer having the second thickness is disposed on the substrate outside a perimeter of the second electrode, and wherein the frame is disposed on the second portion of the piezoelectric layer.
